# EUROPEAN PATENT APPLICATION

(11) **EP 4 632 269 A1**
(43) Date of publication of application: **15.10.2025**
(21) Application number: 23900677.8
(22) Date of filing: 06.12.2023
(51) Int. Cl.: F21S 41/147, F21S 41/25, F21S 41/32, F21S 41/43, H01L 33/00, F21W 102/13, F21Y 115/10

(54) **HEADLIGHT DEVICE**

(30) Priority: 07.12.2022 JP 2022195469; 07.12.2022 JP 2022195470
(71) Applicant: Koito Manufacturing Co., Ltd., Tokyo 141-0001 (JP)
(72) Inventor: TOKUDOME Toyohisa, Shizuoka-shi, Shizuoka 424-8764 (JP); SUZUKI Takahiro, Shizuoka-shi, Shizuoka 424-8764 (JP)
(74) Representative: Hoffmann Eitle
(86) International application number: PCT/JP2023/043585
(87) International publication number: WO 2024/122563

(57) **Abstract**

A semiconductor light emitting element (10) includes a monolithic light emitting face. The light emitting face includes a first portion (151) and a second portion (152) that are arranged in a first direction. A reflector (35) includes a reflective face (351) having a shape based on a paraboloid, and reflects light emitted from the light emitting face with the reflective face (351) to form a low-beam light-distributing pattern in an area ahead of a mobility. A light intensity per unit area of light (L1) emitted from the first portion (151) is higher than a light intensity per unit area of light (L2) emitted from the second portion (152). The first portion (151) is located closer to one end edge (150a) of the light emitting face in the first direction than a center of the light emitting face in the first direction. The one end edge (150a) is associated with an upper edge of the low-beam light-distribution pattern.

## Description

### Field

The presently disclosed subject matter relates to a headlight device adapted to be installed in a mobility.

### Background

Patent Document 1 discloses a headlight device adapted to be installed in a vehicle that is an example of a mobility. The headlight device includes a semiconductor light emitting element and a reflector. The reflector has a reflective face having a shape based on a paraboloid. Light emitted from the semiconductor light emitting element is reflected by the reflective face to form a low-beam light-distribution pattern in an area ahead of the vehicle. One edge of a light emitting face of the semiconductor light emitting element is associated with an upper edge (so-called a cutoff line) of the low-beam light-distribution pattern.

Patent Document 1 also discloses a headlight device provided with a projection lens, a semiconductor light emitting element, a reflector, and a shade. The reflector has a reflective face having a shape based on an elliptical sphere. Light emitted from the semiconductor light emitting element is reflected by the reflective face and caused to pass through the projection lens to form a low-beam light-distribution pattern in an area ahead of the vehicle. The shade defines a shape of an upper edge (so-called a cutoff line) of the low-beam light-distribution pattern by partially shading the light reflected by the reflector.

### Citation List

### Patent Document

Patent Document 1: Japanese Patent Publication No. 2011-238511 A

### Summary of the Invention

### Technical Problem

It is demanded to improve distant visibility attained by the low-beam light-distribution pattern that is formed with the headlight device.

### Solution to Problem

An illustrative aspect of the presently disclosed subject matter may provide a headlight device adapted to be installed in a mobility, comprising:
a semiconductor light emitting element including a monolithic light emitting face; and
a reflector including a reflective face having a shape based on a paraboloid, and configured to reflect light emitted from the light emitting face with the reflective face to form a low-beam light-distributing pattern in an area ahead of the mobility,
wherein the light emitting face includes a first portion and a second portion that are arranged in a first direction;
wherein a light intensity per unit area of light emitted from the first portion is higher than a light intensity per unit area of light emitted from the second portion;
wherein the first portion is located closer to one end edge of the light emitting face in the first direction than a center of the light emitting face in the first direction; and
wherein the one end edge is associated with an upper edge of the low-beam light-distribution pattern.

An illustrative aspect of the presently disclosed subject matter may provide a headlight device adapted to be installed in a mobility, comprising:
a projection lens;
a semiconductor light emitting element including a monolithic light emitting face;
a reflector including a reflective face having a shape based on an elliptical sphere, and configured to reflect light emitted from the light emitting face with the reflective face and cause the light as reflected to pass through the projection lens to form a low-beam light-distributing pattern in an area ahead of the mobility; and
a shade configured to partially block the light reflected by the reflector to define a shape of an upper edge of the low-beam light-distributing pattern,
wherein the light emitting face includes a first portion and a second portion that are arranged in a first direction;
wherein a light intensity per unit area of light emitted from the first portion is higher than a light intensity per unit area of light emitted from the second portion;
wherein the first portion is located closer to one end edge of the light emitting face in the first direction than a center of the light emitting face in the first direction; and
wherein the light emitted from the first portion is partially blocked by the shade.

According to the configuration of each of the above illustrative aspects, a light distribution pattern in which the brightness is locally increased in the vicinity of the upper edge of the low-beam light-distribution pattern can be formed in an area ahead of the mobility while maintaining the amount of the light flux. As a result, it is possible to improve the distant visibility attained by the low-beam light-distribution pattern that is formed with the headlight device. In order to obtain such a light distribution pattern, neither making a special change to the configuration of the reflector, nor using multiple LED elements with different light emitting brightness is necessary. Accordingly, it is possible to suppress enlargement and complication of an optical system of the headlight device.

### Brief Description of Drawings

FIG. 1 illustrates an appearance of an LED element according to one embodiment.
FIG. 2 illustrates a cross-sectional configuration along the line II-II in FIG. 1 as viewed from the arrowed direction.
FIG. 3 illustrates a vehicle in which the LED device is to be installed.
FIG. 4 illustrates an appearance of a headlight device according to one embodiment.
FIG. 5 illustrates a cross section along the line IV-IV of FIG. 4 as viewed from an arrowed direction.
FIG. 6 illustrates a low-beam pattern formed with a headlight device according to a comparative example.
FIG. 7 illustrates an appearance of the reflector of FIG. 4.
FIG. 8 illustrates an operation of the headlight device of FIG. 4.
FIG. 9 illustrates a low-beam pattern formed with the headlight device of FIG. 4.
FIG. 10 illustrates a configuration of a headlight device according to another embodiment.
FIG. 11 illustrates a low-beam pattern formed with the headlight device of FIG. 10.
FIG. 12 illustrates an operation of the headlight device of FIG. 10.
FIG. 13 illustrates a low-beam pattern formed with the headlight device of FIG. 10.

### Description of Embodiments

Exemplary embodiments will be described below in detail with reference to the accompanying drawings. In the drawings used in the following descriptions, the scale thereof is changed as required in order to make each element to a recognizable size.

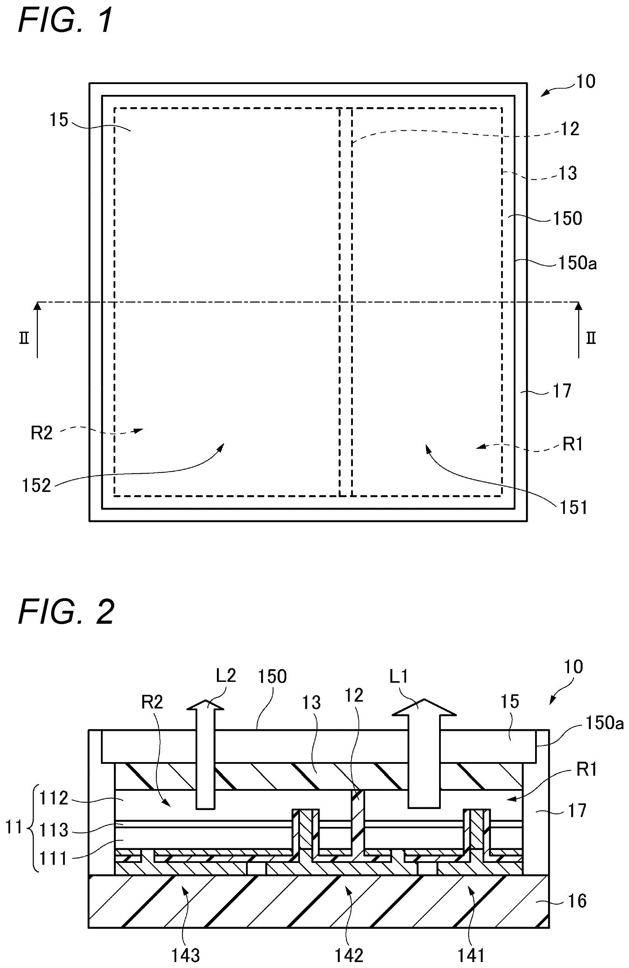

FIG. 1 illustrates an appearance of a light emitting diode element (hereinafter, abbreviated as an LED element) 10 according to an embodiment. The LED element 10 is an example of a semiconductor light emitting element. FIG. 2 illustrates a cross-sectional configuration along the line II-II in FIG. 1 as viewed from the arrowed direction.

The LED element 10 includes a laminated optical semiconductor 11. The laminated optical semiconductor 11 includes a p-type semiconductor layer 111, an n-type semiconductor layer 112, and a light emitting layer 113. The p-type semiconductor layer 111, the n-type semiconductor layer 112, and the light emitting layer 113 are arranged in the up-down direction in FIG. 2. In the following descriptions, the up-down direction in FIG. 2 is referred to as a "laminated direction".

The p-type semiconductor layer 111 is formed of p-type gallium nitride doped with magnesium. The p-type is an example of a first conductive type.

The n-type semiconductor layer 112 is formed of n-type gallium nitride doped with silicon. The n-type is an example of a second conductive type. The second conductive type is a conductive type opposite to the first conductive type.

The light emitting layer 113 is located between the p-type semiconductor layer 111 and the n-type semiconductor layer 112. The light emitting layer 113 has a multiple quantum-well structure including a well layer formed of indium gallium nitride and a barrier layer formed of gallium nitride. The light emitting layer 113 is configured to emit light in accordance with current supply described later.

The LED element 10 includes an insulating portion 12. The insulating portion 12 has electrical insulation property. The insulating portion 12 extends in the laminated direction, and partitions the laminated optical semiconductor 11 into a first region R1 and a second region R2 that are electrically insulated from each other. In other words, each of the first region R1 and the second region R2 includes the p-type semiconductor layer 111, the n-type semiconductor layer 112, and the light emitting layer 113 arranged in the laminated direction.

The first region R1 and the second region R2 are arranged in the left-right direction in FIG. 2. In the following descriptions, the left-right direction in FIG. 2 is referred to as an "arrayed direction". The arrayed direction and the laminated direction intersect with each other. The arrayed direction is an example of a first direction. The laminated direction is an example of a second direction.

In FIGS. 1 and 2, a width dimension of the insulating portion 12 in the arrayed direction as viewed from the laminated direction is enlarged in order to give priority to the visibility. In this example, the insulating portion 12 is formed of silicon oxide such as silicon dioxide. As long as the electrical insulation property can be secured, an appropriate method such as forming a gap can be employed.

The LED element 10 includes a translucent layer 13. The translucent layer 13 extends so as to straddle the first region R1 and the second region R2. The translucent layer 13 is configured to allow passage of the light emitted from the light emitting layer 113. The translucent layer 13 is formed of a material having electrical insulation property. The translucent layer 13 has a monolithic structure.

The term "monolithic structure" as used herein is intended to mean a one-piece structure having no physical discontinuity, and to exclude a structure that is integrated by coupling multiple members in various manners. Examples of the various manners may include adhering, bonding, deposition, welding, engaging, fitting, screwing, and the like.

The LED element 10 includes a first conductive portion 141. The first conductive portion 141 is formed of a conductive material. The first conductive portion 141 is electrically connected to the n-type semiconductor layer 112 in the first region R1.

The LED element 10 includes a second conductive portion 142. The second conductive portion 142 is formed of a conductive material. The second conductive portion 142 electrically connects the p-type semiconductor layer 111 in the first region R1 and the n-type semiconductor layer 112 in the second region R2.

The LED element 10 includes a third conductive portion 143. The third conductive portion 143 is formed of a conductive material. The third conductive portion 143 is electrically connected to the p-type semiconductor layer 111 in the second region R2.

Accordingly, when current is supplied to the first conductive portion 141, the current reaches the second conductive portion 142 via the n-type semiconductor layer 112 and the p-type semiconductor layer 111 in the first region R1, and causes the light emitting layer 113 in the first region R1 to emit light L1. Further, the current reaches the third conductive portion 143 from the second conductive portion 142 via the n-type semiconductor layer 112 and the p-type semiconductor layer 111 in the second region R2, and causes the light emitting layer 113 in the second region R2 to emit light L2.

In other words, the first region R1 and the second region R2 of the laminated optical semiconductor 11 sharing the translucent layer 13 having the monolithic structure serve as two individual light sources that emit light having different light intensities.

The LED element 10 includes a wavelength conversion layer 15. The wavelength conversion layer 15 has a monolithic structure extending so as to straddle the first region R1 and the second region R2. The wavelength conversion layer 15 is disposed so as to cover the translucent layer 13. In other words, the translucent layer 13 is located between the laminated optical semiconductor 11 and the wavelength conversion layer 15. Accordingly, the light L1 and the light L2 that have passed through the translucent layer 13 pass through the wavelength conversion layer 15.

An upper face of the wavelength conversion layer 15 forms a light emitting face 150 of the LED element 10. In other words, the LED element 10 has a monolithic light emitting face 150. The light emitting face 150 includes a first portion 151 and a second portion 152. The first portion 151 is disposed so as to face the first region R1 in the laminated direction. The second portion 152 is disposed so as to face the second region R2 in the laminated direction.

The wavelength conversion layer 15 contains phosphor so as to implement a desired wavelength conversion function with respect to light passing therethrough. In this example, the phosphor is selected so that the light passing through the wavelength conversion layer 15 exhibits white color. Examples of the phosphor include Y₃Al₅O₁₂, Gd₃Al₃O₁₂, Ba₂SiO₄, Sr₂SiO₄, La₃Si₆N₁₁, Y₃Si₆N₁₁, cerium, europium, and the like. The wavelength conversion layer 15 may be implemented by ceramics phosphor, a phosphor-containing glass substrate using low-melting glass, a phosphor-containing resin layer using silicon resin or epoxy resin, or the like.

The light L1 and the light L2 emitted from the laminated optical semiconductor 11 exhibit blue color. When the blue light L1 is incident on the wavelength conversion layer 15, the phosphor emits yellow light. As a result, white light L1 is emitted from the first portion 151. Similarly, when the blue light L2 is incident on the wavelength conversion layer 15, the phosphor emits yellow light. As a result, white light L2 is emitted from the second portion 152.

The LED element 10 includes a substrate 16. The substrate 16 supports the first conductive portion 141, the second conductive portion 142, and the third conductive portion 143. Circuit wirings (not illustrated) electrically connected to the first conductive portion 141, the second conductive portion 142, and the third conductive portion 143 are formed on the surface of the substrate 16. The substrate 16 may support circuit elements other than the LED 10.

The LED element 10 includes a light reflecting portion 17. The light reflecting portion 17 is configured to hold at least side faces of the laminated optical semiconductor 11, the insulating portion 12, the translucent layer 13, the first conductive portion 141, the second conductive portion 142, the third conductive portion 143, and the wavelength conversion layer 15. The light reflecting portion 17 is formed by solidifying a transparent material having electrical insulation property in which a light scattering material such as alumina or tungsten oxide is dispersed. The light reflecting portion 17 is configured to reflect light emitted outward from the side faces of the laminated optical semiconductor 11, the translucent layer 13, and the wavelength conversion layer 15 and return the light to the inside of the wavelength conversion layer 15. As a result, it is possible to improve utilization efficiency of the light emitted from the upper face of the wavelength conversion layer 15. Examples of the transparent material include silicone resin and epoxy resin.

An area of the first region R1 as viewed from the laminated direction is smaller than an area of the second region R2 as viewed from the same direction. Accordingly, density of the current flowing through the first region R1 is higher than density of the current flowing through the second region R2. As a result, as illustrated in FIG. 2, light intensity per unit area of the light L1 emitted from the light emitting layer 113 of the first region R1 is higher than light intensity per unit area of the light L2 emitted from the light emitting layer 113 of the second region R2. The unit of the light intensity per unit area is [W/mm²]. The light intensity per unit area can be rephrased as an amount of light energy per unit area or an amount of photons per unit area.

In other words, since the laminated optical semiconductor 11 formed with the p-type semiconductor layer 111, the n-type semiconductor layer 112, and the light emitting layer 113 is partitioned by the insulating portion 12 into the first region R1 and the second region R2 having different areas, it is possible to obtain the light L1 and the light L2 having different light intensities per unit area without increasing the area of the translucent layer 13 while suppressing a decrease in the light emitting efficiency for obtaining a given light flux. In other words, it is possible to provide an LED element having a sole light emitting face capable of exhibiting a contrast of brightness while suppressing a decrease in the light emitting efficiency and an increase in the size of the element.

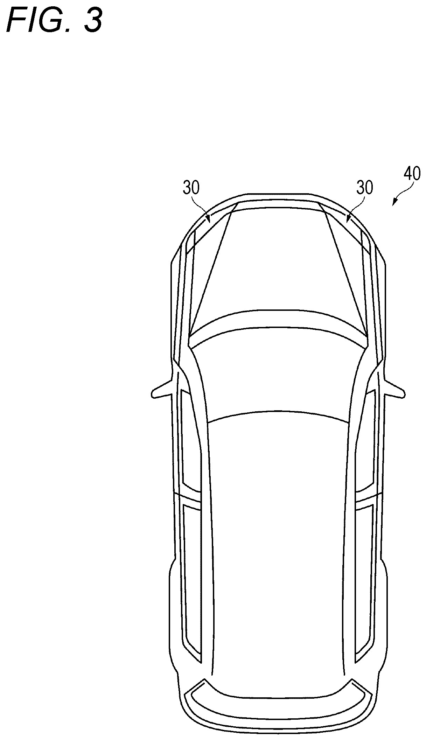

FIG. 3 illustrates a vehicle 40 in which a headlight device 30 according to an embodiment is to be installed. The headlight device 30 is installed in a left front corner portion and a right front corner portion of the vehicle 40. The headlight device 30 is configured to light an area ahead of the vehicle 40. The shape of the vehicle 40 is merely illustrative. The vehicle 40 is an example of a mobility.

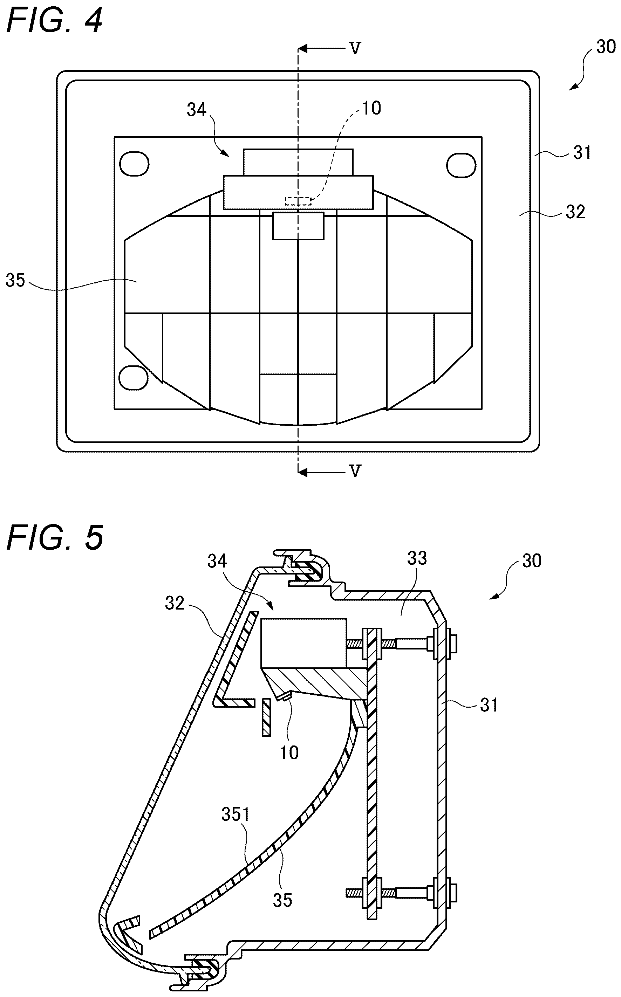

FIG. 4 illustrates an appearance of the headlight device 30 according to one embodiment. FIG. 5 illustrates a cross section along the line V-V in FIG. 4 as viewed from the arrowed direction. The headlight device 30 includes a housing 31 and a translucent cover 32. The housing 31 and the translucent cover 32 define a lamp chamber 33.

The headlight device 30 includes a lamp unit 34. The lamp unit 34 is disposed in the lamp chamber 33. The lamp unit 34 includes the LED element 10 described above as a light source. The lamp unit 34 includes a reflector 35. The reflector 35 is disposed on a path of light emitted from the LED element 10. The reflector 35 has a reflective face 351 having a shape based on a paraboloid. The light emitting face of the LED element 10 is disposed at or near a focal point of the reflective face 351.

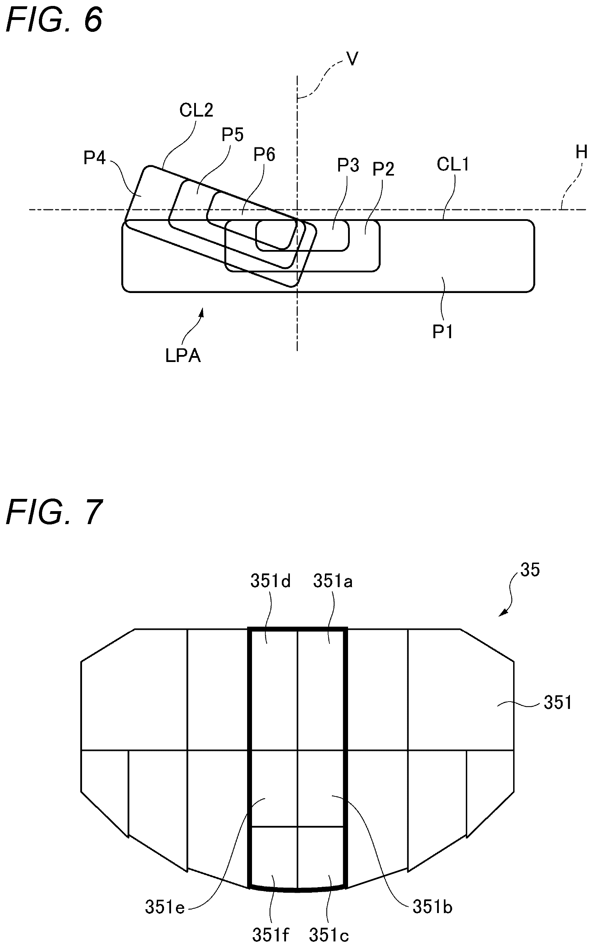

FIG. 6 illustrates a low-beam pattern LPA according to a comparative example. The low-beam pattern LPA is formed in an area ahead of the vehicle 40 by reflecting, with the reflector 35, light having a uniform brightness that is emitted from a light emitting face of a conventional LED element. The low-beam pattern LPA is a light distribution pattern formed by light emitted toward a portion of the area to be lighted where is located at a relatively short distance from the vehicle 40.

A symbol H represents a horizontal reference line. A symbol V represents a vertical reference line. The horizontal reference line H and the vertical reference line V are orthogonal to each other.

The low-beam pattern LPA is defined in such a manner that glare is not imparted to a mobility located in a position ahead of the vehicle 40. Specifically, the low-beam pattern LPA includes a first cutoff line CL1 and a second cutoff line CL2. The first cutoff line CL1 and the second cutoff line CL2 form at least a portion of an upper edge of the low-beam pattern LPA.

The first cutoff line CL1 extends in parallel with the horizontal reference line H. The low-beam pattern LPA is positioned such that the first cutoff line CL1 is located at least on an oncoming lane. The second cutoff line CL2 extends obliquely upward from one end of the first cutoff line CL1. The low-beam pattern LPA is positioned such that the second cutoff line CL2 is located at least on an own lane.

As illustrated in FIG. 7, the reflective face 351 of the reflector 35 includes a first region 351a, a second region 351b, a third region 351c, a fourth region 351d, a fifth region 351e, and a sixth region 351f. Each of these regions is formed as a smooth curved face. The adjacent regions are connected to each other with a step or a crease.

As illustrated in FIG. 6, the low-beam pattern LPA includes a first projected image P1, a second projected image P2, a third projected image P3, a fourth projected image P4, a fifth projected image P5, and a sixth projected image P6.

The first projected image P1 is formed by reflecting the light emitted from the light source onto the first region 351a of the reflector 35. The first projected image P1 has a shape contributing to the formation of the first cutoff line CL1. In other words, the position and shape of the first region 351a are determined so that the first projected image P1 having a prescribed shape can be formed at a prescribed position.

The second projected image P2 is formed by reflecting the light emitted from the light source onto the second region 351b of the reflector 35. The second projected image P2 has a shape contributing to the formation of the first cutoff line CL1. In other words, the position and shape of the second region 351b are determined so that the second projected image P2 having a prescribed shape can be formed at a prescribed position.

The third projected image P3 is formed by reflecting the light emitted from the light source onto the third region 351c of the reflector 35. The third projected image P3 has a shape contributing to the formation of the first cutoff line CL1. In other words, the position and shape of the third region 351c are determined so that the third projected image P3 having a prescribed shape can be formed at a prescribed position.

The fourth projected image P4 is formed by reflecting the light emitted from the light source onto the fourth region 351d of the reflector 35. The fourth projected image P4 has a shape contributing to the formation of the second cutoff line CL2. In other words, the position and shape of the fourth region 351d are determined so that the fourth projected image P4 having a prescribed shape can be formed at a prescribed position.

The fifth projected image P5 is formed by reflecting the light emitted from the light source into the fifth region 351e of the reflector 35. The fifth projected image P5 has a shape contributing to the formation of the second cutoff line CL2. In other words, the position and shape of the fifth region 351e are determined so that the fifth projected image P5 having a prescribed shape can be formed at a prescribed position.

The sixth projected image P6 is formed by reflecting the light emitted from the light source onto the sixth region 351f of the reflector 35. The sixth projected image P6 has a shape contributing to the formation of the second cutoff line CL2. In other words, the position and shape of the sixth region 351f are determined so that the sixth projected image P6 having a prescribed shape can be formed at a prescribed position.

In other words, the low-beam pattern LPA is formed by overlapping the first projected image P1, the second projected image P2, the third projected image P3, the fourth projected image P4, the fifth projected image P5, and the sixth projected image P6. A portion where more projected images are overlapped has higher brightness.

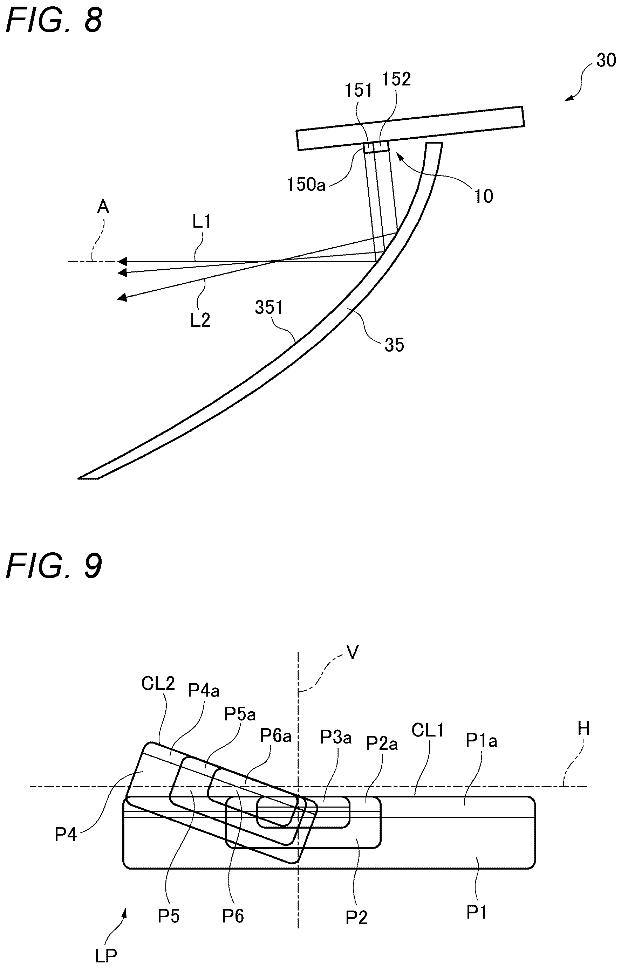

FIG. 8 illustrates a state that the light L1 and the light L2 emitted from the LED element 10 according to the present embodiment are reflected by a specific region on the reflective face 351 of the reflector 35. A symbol A represents an optical axis corresponding to an intersection of the horizontal reference line H and the vertical reference line V illustrated in FIG. 6.

FIG. 9 illustrates a low-beam pattern LP formed by the LED element 10 and the reflector 35 in an area ahead of the vehicle 40. Substantially the same elements as the low-beam pattern LPA illustrated in FIG. 7 are denoted with the same reference symbols, and repetitive descriptions thereof will be omitted.

As illustrated in FIG. 1, the first region R1 of the LED element 10 is located closer to one end edge 150a of the light emitting face 150 in the arrayed direction than the center of the light emitting face 150 in the same direction. As illustrated in FIG. 8, the arrangement of the LED elements 10 in the headlight device 30 is so determined that the one end edge 150a corresponds to the upper end edge of the low-beam pattern LP.

As a result, the light L1 emitted from the light emitting layer 113 in the first region R1 passes through a position closer to the optical axis A than the light L2 emitted from the light emitting layer 113 in the second region R2. As a result, as illustrated in FIG. 9, in the low-beam pattern LP, a region with higher brightness is locally formed in the vicinity of the upper edge.

Specifically, a first high-brightness projected image P1a, a second high-brightness projected image P2a, and a third high-brightness projected image P3a are formed by the light L1 emitted from the first region R1 so as to form a part of the first cutoff line CL1 while being adjacent to a first projected image P1, a second projected image P2, and a third projected image P3 formed by the light L2 emitted from the second region R2, respectively.

Similarly, a fourth high-brightness projected image P4a, a fifth high-brightness projected image P5a, and a sixth high-brightness projected image P6a are formed by the light L1 emitted from the first region R1 so as to form a part of the second cutoff line CL2 while being adjacent to a fourth projected image P4, a fifth projected image P5, and a sixth projected image P6 formed by the light L2 emitted from the second region R2, respectively.

Accordingly, by using the LED element 10 according to the present embodiment as a light source of the headlight device 30, a light distribution pattern in which the brightness is locally increased in the vicinity of the upper edge of the low-beam pattern LP can be formed in an area ahead of the vehicle 40 while maintaining the amount of the light flux. As a result, it is possible to improve the distant visibility attained by the low-beam pattern LP that is formed with the headlight device 30. In order to obtain such a light distribution pattern, neither making a special change to the configuration of the reflector 35, nor using multiple LED elements with different light emitting brightness is necessary. Accordingly, it is possible to suppress enlargement and complication of an optical system of the headlight device 30.

As illustrated in FIG. 8, as for light directed to a specific region on the reflective face 351 of the reflector 35, the posture of the LED element 10 in the headlight device 30 is determined so that the light L1 emitted from the first region R1 is incident on a position in that region where is farther from the LED element 10 than a position in that region on which the light L2 emitted from the second region R2 is incident. The "specific region" is a region having an arbitrary area and shape defined on the reflective face 351. Each of the first region 351a, the second region 352b, the third region 353c, the fourth region 351d, the fifth region 351e, and the sixth region 351f described above may be an example of the specific region.

However, as long as the light L1 and the light L2 incident on the reflective face 351 can satisfy the above-described positional relationship, the posture of the LED element 10 in the headlight device 30 can be appropriately changed by interposing an appropriate optical system between the LED element 10 and the reflector 35.

As long as the one end edge 150a of the light emitting face 150 of the LED element 10 is associated with the upper edge of the low-beam pattern LP, the positional relationship between the light L1 and the light L2 incident on the reflective face 351 can be appropriately changed by interposing an appropriate optical system in a subsequent stage of the reflector 35.

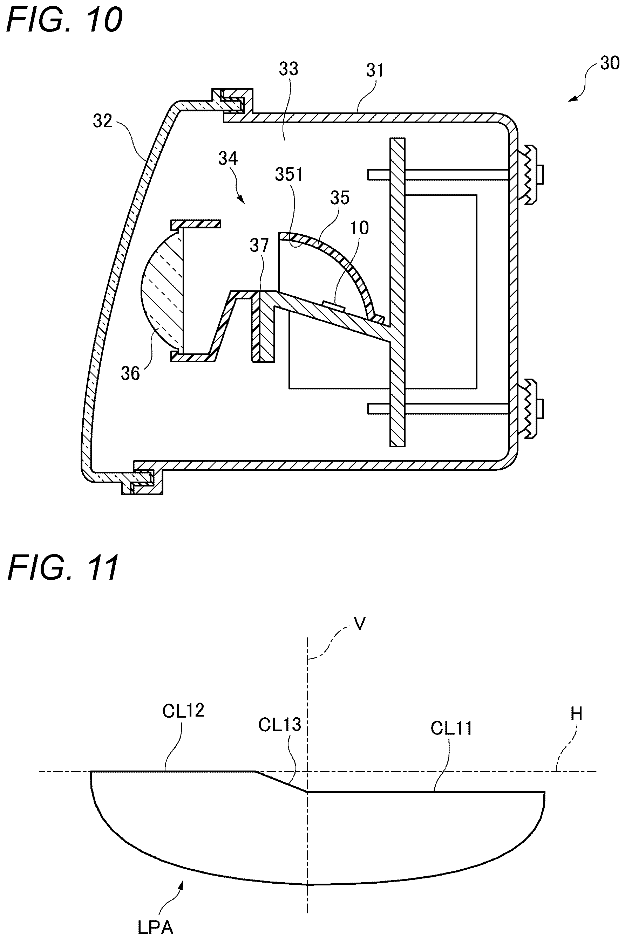

FIG. 10 illustrates a configuration of a headlight device 30 according to another embodiment. The headlight device 30 includes a housing 31 and a translucent cover 32. The housing 31 and the translucent cover 32 define a lamp chamber 33.

The headlight device 30 includes a lamp unit 34. The lamp unit 34 is disposed in the lamp chamber 33. The lamp unit 34 includes the LED element 10 described above as a light source. The lamp unit 34 includes a reflector 35 and a projection lens 36.

The reflector 35 is disposed on a path of light emitted from the LED element 10. The reflector 35 has a reflective face 351 having a shape based on an elliptical sphere. The projection lens 36 is disposed such that a rear focal point is located at or near the first focal point of the reflective face 351. The light emitting face of the LED element 10 is disposed at or near the second focal point of the reflective face 351.

FIG. 11 illustrates a low-beam pattern LPA according to a comparative example. The low-beam pattern LPA is formed in an area ahead of the vehicle 40 by reflecting, with the reflector 35, light having a uniform brightness that is emitted from a light emitting face of a conventional LED element. The low-beam pattern LPA is a light distribution pattern formed by light emitted toward a portion of the area to be lighted where is located at a relatively short distance from the vehicle 40.

A symbol H represents a horizontal reference line. A symbol V represents a vertical reference line. The horizontal reference line H and the vertical reference line V are orthogonal to each other.

The low-beam pattern LPA is defined in such a manner that glare is not imparted to a mobility located in a position ahead of the vehicle 40. Specifically, the low-beam pattern LPA includes a first cutoff line CL11, a second cutoff line CL12, and a third cutoff line CL13. The first cutoff line CL11, the second cutoff line CL12, and the third cutoff line CL13 form at least a portion of an upper edge of the low-beam pattern LPA.

The first cutoff line CL11 extends in parallel with the horizontal reference line H. The low-beam pattern LPA is positioned such that the first cutoff line CL11 is located at least on an oncoming lane. The second cutoff line CL12 extends in parallel to the horizontal reference line H above the first cutoff line CL11. The low-beam pattern LPA is positioned such that the second cutoff line CL12 is located at least on an own lane. The third cutoff line CL13 extends obliquely so as to connect one ends of the first cutoff line CL11 and the second cutoff line CL12.

As illustrated in FIG. 10, the lamp unit 34 includes a shade 37. The light emitted from the LED element 10 and reflected by the reflector 35 is partially shaded by the shade 37. Although not illustrated, the shade 37 has an upper edge having a shape corresponding to the first cutoff line CL11, the second cutoff line CL12, and the third cutoff line CL13. Light passing over the upper edge of the shade 37 is projected by the projection lens 36 to an area ahead of the vehicle 40 to form the low-beam pattern LPA. In other words, the shade 37 defines the shape of the upper edge of the low-beam pattern LPA.

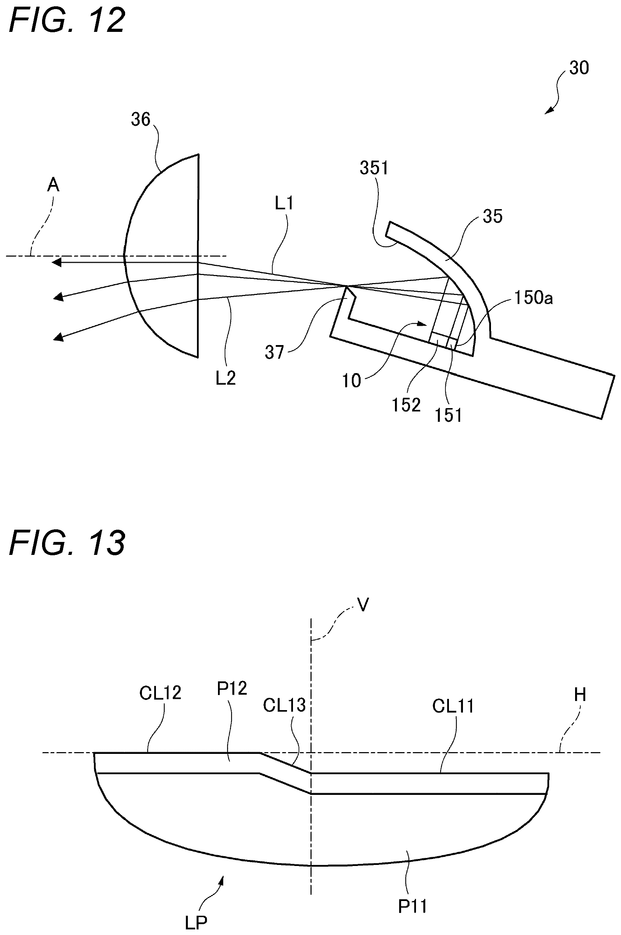

FIG. 12 illustrates a state that the light L1 and the light L2 emitted from the LED element 10 according to the present embodiment are reflected by the specific region on the reflective face 351 of the reflector 35. A symbol A represents an optical axis corresponding to an intersection of the horizontal reference line H and the vertical reference line V illustrated in FIG. 11.

FIG. 13 illustrates a low-beam pattern LP formed by the LED element 10 and the reflector 35 in an area ahead of the vehicle 40. Substantially the same elements as the low-beam pattern LPA illustrated in FIG. 11 are denoted by the same reference symbols, and repetitive descriptions thereof will be omitted.

As illustrated in FIG. 1, the first region R1 of the LED element 10 is located closer to one end edge 150a of the light emitting face 150 in the arrayed direction than the center of the light emitting face 150 in the same direction. As illustrated in FIG. 12, the arrangement of the LED element 10 in the headlight device 30 is determined so that the light L1 emitted from the light emitting layer 113 in the first region R1 is partially shaded by the shade 37.

As a result, the light L1 emitted from the light emitting layer 113 in the first region R1 passes through a position closer to the optical axis A than the light L2 emitted from the light emitting layer 113 in the second region R2. As a result, as illustrated in FIG. 13, in the low-beam pattern LP, a region with higher brightness is locally formed in the vicinity of the upper edge.

Specifically, the low-beam pattern LP includes a first projected image P11 and a second projected image P12. The first projected image P11 is a projected image formed by the light L1 emitted from the first region R1. The second projected image P12 is a projected image formed by the light L2 emitted from the second region R2. The brightness of the first projected image P11 is higher than the brightness of the second projected image P12. The first projected image P11 is formed so as to include the first cutoff line CL11, the second cutoff line CL12, and the third cutoff line CL13 while being adjacent to the second projected image P12.

Accordingly, by using the LED element 10 according to the present embodiment as a light source of the headlight device 30, a light distribution pattern in which the brightness is locally increased in the vicinity of the upper edge of the low-beam pattern LP can be formed in an area ahead of the vehicle 40 while maintaining the amount of the light flux. As a result, it is possible to improve the distant visibility attained by the low-beam pattern LP that is formed with the headlight device 30. In order to obtain such a light distribution pattern, neither making a special change to the configuration of the reflector 35, nor using multiple LED elements with different light emitting brightness is necessary. Accordingly, it is possible to suppress enlargement and complication of an optical system of the headlight device 30.

As illustrated in FIG. 12, with respect to light directed to a specific region on the reflective face 351 of the reflector 35, the posture of the LED element 10 in the headlight device 30 is determined so that the light L1 emitted from the first region R1 is incident on a position in that region where is farther from the projection lens 36 than a position in that region on which the light L2 emitted from the second region R2 is incident. The "specific region" is a region having an arbitrary area and shape defined on the reflective face 351.

According to such a configuration, it is possible to easily reduce the amount of light shaded by the shade 37. However, as long as the light L1 and the light L2 incident on the reflective face 351 can satisfy the above-described positional relationship, the posture of the LED element 10 in the headlight device 30 can be appropriately changed by interposing an appropriate optical system between the LED element 10 and the reflector 35.

Each configuration described above is merely illustrative for facilitating understanding of the presently disclosed subject matter. Each exemplary configuration can be appropriately changed or combined with another exemplary configuration.

In the above exemplary embodiment, the n-type semiconductor layer 112 is located closer to the translucent layer 13 than the p-type semiconductor layer 111. However, the positional relationship between the p-type semiconductor layer 111 and the n-type semiconductor layer 112 with respect to the translucent layer 13 may be reversed as long as a desired function can be realized as a light emitting diode.

In the above exemplary embodiment, the laminated optical semiconductor 11 is configured to serve as a light emitting diode. However, the laminated optical semiconductor 11 may be configured to serve as a laser diode or an electroluminescent element.

In the above exemplary embodiment, the wavelength conversion layer 15 is provided in order to obtain white light. However, the wavelength conversion layer 15 may be omitted according to the relationship between the color of the light emitted from the light emitting layer 113 and the color necessary as the light source.

In the above exemplary embodiment, the headlight device 30 is installed in the vehicle 40 with four wheels. However, the headlight device 30 may be installed in a motorcycle with two or three wheels. The types of the motorcycle with two or three wheels may be any of a saddled type, a scooter type, and a standing type. The motorcycle with two or three wheels is also an example of the mobility. The headlight device 30 may be installed in a road railway or the like with four or more wheels. The road railway is also an example of the mobility. The number of the headlight devices 30 installed in the front portion of the mobility can be appropriately determined in accordance with the specification of the mobility.

The present application is based on Japanese Patent Application No. 2022-195469 filed on December 7, 2022, and Japanese Patent Application No. 2022-195470 filed on December 7, 2022, the entire contents of which are incorporated herein by reference.

## Claims

1. A headlight device adapted to be installed in a mobility, comprising:
a semiconductor light emitting element including a monolithic light emitting face; and
a reflector including a reflective face having a shape based on a paraboloid, and configured to reflect light emitted from the light emitting face with the reflective face to form a low-beam light-distributing pattern in an area ahead of the mobility,
wherein the light emitting face includes a first portion and a second portion that are arranged in a first direction;
wherein a light intensity per unit area of light emitted from the first portion is higher than a light intensity per unit area of light emitted from the second portion;
wherein the first portion is located closer to one end edge of the light emitting face in the first direction than a center of the light emitting face in the first direction; and
wherein the one end edge is associated with an upper edge of the low-beam light-distribution pattern.

2. The headlight device according to claim 1,
wherein, as for light directed to a specific region on the reflective surface from the semiconductor light emitting element, the light emitted from the first portion is incident on a position in the specific region where is farther from the semiconductor light emitting element than a position in the specific region on which the light emitted from the second portion is incident.

3. The headlight device according to claim 1 or 2,
wherein the semiconductor light emitting element includes:
a first semiconductor layer having a first conductive type;
a second semiconductor layer having a second conductive type that is opposite to the first conductive type;
a light emitting layer located between the first semiconductor layer and the second semiconductor layer;
an insulating portion partitioning the first semiconductor layer, the second semiconductor layer, and the light emitting layer into a first region and a second region that are electrically isolated;
a translucent layer having a monolithic structure extending so as to straddle the first region and the second region, and configured to allow light emitted from the light emitting layer to pass through;
a first conductive portion electrically connected to the second semiconductor layer in the first region;
a second conductive portion electrically connecting the first semiconductor layer in the first region and the second semiconductor layer in the second region; and
a third conductive portion electrically connected to the first semiconductor layer in the second region;
wherein the first semiconductor layer, the second semiconductor layer, and the light emitting layer are arranged in a second direction intersecting the first direction;
wherein an area of the first region as viewed from the second direction is smaller than an area of the second region as viewed from the second direction;
wherein the first portion faces the first region in the second direction; and
wherein the second portion faces the second region in the second direction.

4. A headlight device adapted to be installed in a mobility, comprising:
a projection lens;
a semiconductor light emitting element including a monolithic light emitting face;
a reflector including a reflective face having a shape based on an elliptical sphere, and configured to reflect light emitted from the light emitting face with the reflective face and cause the light as reflected to pass through the projection lens to form a low-beam light-distributing pattern in an area ahead of the mobility; and
a shade configured to partially block the light reflected by the reflector to define a shape of an upper edge of the low-beam light-distributing pattern,
wherein the light emitting face includes a first portion and a second portion that are arranged in a first direction;
wherein a light intensity per unit area of light emitted from the first portion is higher than a light intensity per unit area of light emitted from the second portion;
wherein the first portion is located closer to one end edge of the light emitting face in the first direction than a center of the light emitting face in the first direction; and
wherein the light emitted from the first portion is partially blocked by the shade.

5. The headlight device according to claim 4,
wherein, as for light directed to a specific region on the reflective surface from the semiconductor light emitting element, the light emitted from the first portion is incident on a position in the specific region where is farther from the projection lens than a position in the specific region on which the light emitted from the second portion is incident.

6. The headlight device according to claim 4 or 5,
wherein the semiconductor light emitting element includes:
a first semiconductor layer having a first conductive type;
a second semiconductor layer having a second conductive type that is opposite to the first conductive type;
a light emitting layer located between the first semiconductor layer and the second semiconductor layer;
an insulating portion partitioning the first semiconductor layer, the second semiconductor layer, and the light emitting layer into a first region and a second region that are electrically isolated;
a translucent layer having a monolithic structure extending so as to straddle the first region and the second region, and configured to allow light emitted from the light emitting layer to pass through;
a first conductive portion electrically connected to the second semiconductor layer in the first region;
a second conductive portion electrically connecting the first semiconductor layer in the first region and the second semiconductor layer in the second region; and
a third conductive portion electrically connected to the first semiconductor layer in the second region;
wherein the first semiconductor layer, the second semiconductor layer, and the light emitting layer are arranged in a second direction intersecting the first direction;
wherein an area of the first region as viewed from the second direction is smaller than an area of the second region as viewed from the second direction;
wherein the first portion faces the first region in the second direction; and
wherein the second portion faces the second region in the second direction.
